# EUROPEAN PATENT SPECIFICATION

(11) **EP 2 270 579 B1**
(45) Date of publication and mention of the grant of the patent: **18.05.2016**
(21) Application number: 10184890.1
(22) Date of filing: 13.12.2002
(51) Int. Cl.: G02F 1/1335, G09G 3/20, G09G 3/36, G02F 1/1343

(54) **Color flat panel display sub-pixel arrangements and layouts for sub-pixel rendering with increased modulation transfer function**
Flache Farbanzeigeeinheit mit Sub-Pixel-Anordnung und Sub-Pixel-Wiedergabe mit erhöhter Modulationstransfer-Funktion
Agencements et dispositions de sous-pixels d'écran plat couleur pour rendu de sous-pixels avec fonction de transfert de modulation améliorée

(30) Priority: 07.01.2002 US 346738 P; 13.09.2002 US 243094; 22.10.2002 US 278353; 22.10.2002 US 278352
(43) Date of publication of application: 05.01.2011
(62) Divisional of application: 02790121.4
(73) Proprietor: Samsung Display Co., Ltd., Gyeonggi-do (KR)
(72) Inventor: Brown Elliott, Candice, Hellen, CA 95401 (US); Credelle, Thomas, Lloyd, Morgan Hill, CA 95037 (US); Higgins, Michael, Francis, Duncan Mills, CA 95430 (US)
(74) Representative: Boult Wade Tennant

(56) References cited:
- EP-A- 0 671 650
- EP-A2- 0 322 106
- JP-A- 3 078 390
- US-B1- 6 327 008
- BROWN ELLIOTT C H: "REDUCING PIXEL COUNT WITHOUT REDUCING IMAGE QUALITY A NEW FPD COLOR-PIXEL ARRANGEMENT OFFERS REDUCED BLUE RESOLUTION, WHICH OFFERS A BETTER MATCH FOR HUMAN VISION AND PROMISES TO LOWER DISPLAY COST", INFORMATION DISPLAY, PALISADES INSTITUTE FOR RESEARCH SERVICES, NEW YORK, NY, US, vol. 15, no. 12, December 1999 (1999-12), pages 22-25, XP000879887, ISSN: 0362-0972

## Description

### BACKGROUND

The present application relates to improvements to display layouts, and, more particularly, to improved color pixel arrangements, means of addressing used in displays, and to data format conversion methods for these displays.

Full color perception is produced in the eye by three-color receptor nerve cell types called cones. The three types are sensitive to different wavelengths of light: long, medium, and short ("red", "green", and "blue", respectively). The relative density of the three differs significantly from one another. There are slightly more red receptors than green receptors. There are very few blue receptors compared to red or green receptors.

The human vision system processes the information detected by the eye in several perceptual channels: luminance, chromanance, and motion. Motion is only important for flicker threshold to the imaging system designer. The luminance channel takes the input from only the red and green receptors. In other words, the luminance channel is "color blind". It processes the information in such a manner that the contrast of edges is enhanced. The chromanance channel does not have edge contrast enhancement Since the luminance channel uses and enhances every red and green receptor, the resolution of the luminance channel is several times higher than the chromanance channels. Consequently, the blue receptor contribution to luminance perception is negligible. The luminance channel thus acts as a spatial frequency signal band pass filter. Its peak response is at 35 cycles per degree (cycles/°). It limits the response at 0 cycles/° and at 50 cycles/° in the horizontal and vertical axis. This means that the luminance channel can only tell the relative brightness between two areas within the field of view. It cannot tell the absolute brightness. Further, if any detail is finer than 50 cycles/°, it simply blends together. The limit in the horizontal axis is slightly higher than the vertical axis. The limit in the diagonal axes is somewhat lower.

The chromanance channel is further subdivided into two sub-channels, to allow us to see full color. These channels are quite different from the luminance channel, acting as low pass filters. One can always tell what color an object is, no matter how big it is in our field of view. The red/green chromanance sub-channel resolution limit is at 8 cycles/°, while the yellow/blue chromanance sub-channel resolution limit is at 4 cycles/°. Thus, the error introduced by lowering the red/green resolution or the yellow/blue resolution by one octave will be barely noticeable by the most perceptive viewer, if at all, as experiments at Xerox and NASA, Ames Research Center (see, e.g., R. Martin, J. Gille, J. Larimer, Detectability of Reduced Blue Pixel Count in Projection Displays, SID Digest 1993) have demonstrated.

The luminance channel determines image details by analyzing the spatial frequency Fourier transform components. From signal theory, any given signal can be represented as the summation of a series of sine waves of varying amplitude and frequency. The process of teasing out, mathematically, these sine-wave-components of a given signal is called a Fourier Transform. The human vision system responds to these sine-wave-components in the two-dimensional image signal.

Color perception is influenced by a process called "assimilation" or the Von Bezold color blending effect This is what allows separate color pixels (also known as sub-pixels or emitters) of a display to be perceived as a mixed color. This blending effect happens over a given angular distance in the field of view. Because of the relatively scarce blue receptors, this blending happens over a greater angle for blue than for red or green. This distance is approximately 0.25° for blue, while for red or green it is approximately 0.12°. At a viewing distance of twelve inches, 0.25° subtends 50 mils (1,270 µ) on a display. Thus, if the blue pixel pitch is less than half (625 µ) of this blending pitch, the colors will blend without loss of picture quality. This blending effect is directly related to the chromanance sub-channel resolution limits described above. Below the resolution limit, one sees separate colors, above the resolution limit, one sees the combined color.

JP 03 078390 discloses a subpixel arrangement comprising red, green and blue subpixels as an 8 subpixel repeating group, as defined in the preamble of claim 1.

EP 0322106 discloses a subpixel arrangement having more subpixels of a first color than of a second color.

### BRIEF DESCRIPTION OF THE DRAWINGS

The accompanying drawings, which are incorporated in, and constitute a part of this specification illustrate various implementations and embodiments disclosed herein.
Figure 1A shows an arrangement of four-color pixel elements in an array, in a single plane, for a display device, having a repeat cell consisting of eight sub-pixels.
Figure 1B shows an arrangement of three-color pixel elements in an array, in a single plane, for a display device, having a repeat cell of consisting of eight sub-pixels generated by selecting and defining four of the eight sub-pixels of Figure 1A as the same color.
Figure 1C shows an arrangement of three-color pixel elements in an array, in a single plane, for a display device, having a repeat cell of consisting of eight sub-pixels generated by selecting and defining four of the eight sub-pixels of Figure 1A as the same color and reducing their widths.
Figure 2 shows a schematic of an electronic drive arrangement for the arrangement of sub-pixels shown in Figures 1A, 1B, and 1C.
Figures 3A and 3B illustrate the relative polarities of active matrix dot inversion drive methods for a Liquid Crystal Display using the arrangement of color sub-pixels of Figure 1C and the drive arrangement of Figure 2.
Figures 4A, 4B, 4C, and 4D illustrate a set of green, blue, and red resample areas separately and overlaid, respectively, for the arrangement of sub-pixels of Figure 1C.
Figures 5A, 5B, 5C, and 5D illustrate the set of green, blue, and red resample areas of Figures 4A, 4B, 4C, and 4D respectively, overlaid on the arrangement of sub-pixels of Figure 1C to show their relative positions.
Figure 5E illustrates two logical pixels displayed on the arrangement of Figure 1C, resulting from the sub-pixel rendering operation of the resample areas of Figure 4D.
Figure 6A illustrates two logical pixels displayed on the arrangement of Figure 1C, resulting from the sub-pixel rendering operation of the resample areas of Figure 6D.
Figures 6B, 6C, and 6D illustrate a set of blue and red resample areas separately, and overlaid along with the green resample areas illustrated in Figure 4A on arrangement of sub-pixels of Figure 1C, respectively.
Figure 7A illustrates the set of green, blue, and red resample areas of Figures 4A, 4B, and 4C respectively, overlaid show their relative positions.
Figure 7B illustrates the arrangement of resample areas of Figure 7A overlaid on the arrangement of sub-pixels of Figure 1C to show their relative positions.
Figures 8A and 8B show other embodiments of the octal subpixel arrangement with various vertical displacements of the subpixels.
Figures 9A and 9B show subpixel arrangements which do not fall within the scope of the claims. In particular, they show an octal subpixel arrangement of various displacements of the split majority subpixel within the subpixel grouping.
Figure 10 depicts a system incorporating sub-pixel rendering techniques suitable to drive a panel made in accordance with the various embodiments described herein.
Figures 11A and 11B depict two particular embodiments of flowcharts to perform software and hardware sub-pixel rendering on a suitable display.
Figure 12 is one particular embodiment of an implementation of a display made in accordance with several embodiments herein disclosed.

### DETAILED DESCRIPTION

Reference will now be made in detail to implementations and embodiments of the invention, examples of which are illustrated in the accompanying drawings. Wherever possible, the same reference numbers will be used throughout the drawings to refer to the same or like parts.

### Sub-Pixel Arrangements

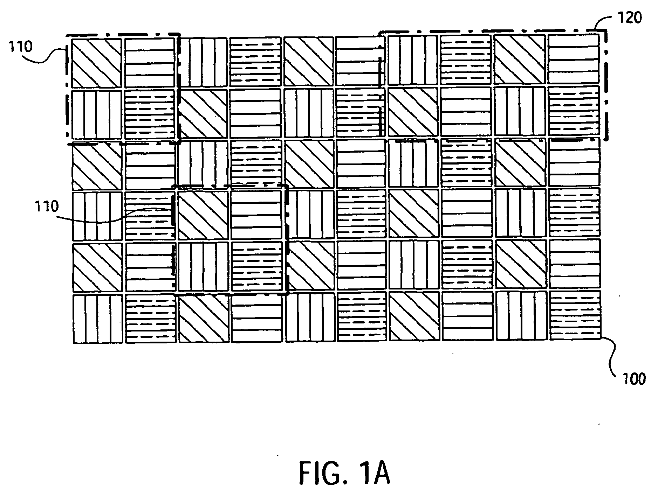

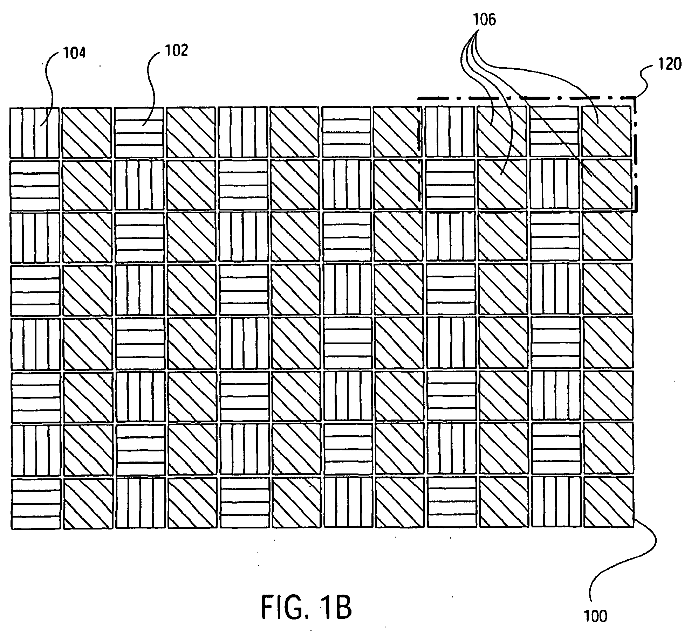

Figure 1A shows an arrangement of sub-pixel emitters 100 having four color emitters in groupings 110 that is shifted down every other column group by one sub-pixel. This creates a larger rectilinearly repeating cell group 120 of eight sub-pixels. This layout was introduced in the '094 application (US 2004/0051724). Also disclosed in the '094 application is the practice of setting a plurality of the sub-pixels within the repeat cell to the same color point, an example of which is illustrated in Figure 1B, wherein four of the emitters 106 in the eight emitter repeat cell group 120 are set to the same color. For example, these four emitters 106 may be set to be luminance adjusted (i.e. balanced) green in color. For example, the other sub-pixel emitters may be set to be red 104 and blue 102. The luminance balanced green 106 sub-pixels have twice the area, i.e., "real-estate," per color as the red 104 and blue 102 sub-pixels, but being balanced to have the same luminance as the red 104 sub-pixels, the total green energy is balanced to produce a pleasing white point when all sub-pixels are illuminated fully. The manner of balancing the luminance of the green color sub-pixel was previously disclosed in the '094 application.

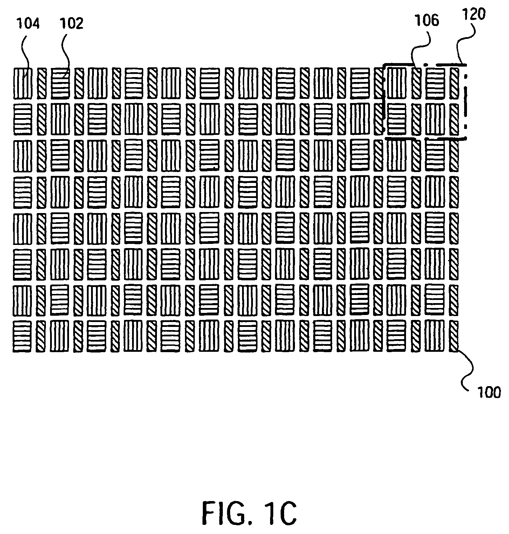

In Figure 1C, the four sub-pixel emitters 106 are reduced in size and aspect ratio compared to the other two sub-pixel emitters 104 and 102. The minority sub-pixels 104 and 102 may also be adjusted in aspect ratio. In this example, the relative size of sub-pixel 106 is adjusted to be one half of that of sub-pixels 104 or 102. As before, the colors may be assigned as desired. It should also be noted that although the repeat octal grouping is shown that the majority color sub-pixels occupy the second and fourth columns, it also suffices that the majority sub-pixels could occupy the first and the third columns as well.

In another embodiment, the colors are assigned as red 104, blue 102, and non-luminance balanced green 106. Since there are twice as many green 106 as there are of the other two colors, red 104 and blue 102, the result is a pleasing white point when all sub-pixels are illuminated fully.

In this or another color assignment embodiment, the sub-pixel aspect ratios may be adjusted so that the display array 100 consists of square repeat cell groups 120. This will put the majority color sub-pixel emitter 106 on a square grid. It will also put the minority color sub-pixel emitters 102 and 104 on, or nearly on, an idealized "checkerboard". For an example of another color assignment embodiments, sub-pixels 106 could be assigned the color red and sub-pixels 104 could be assigned the color green in Figures 1B and 1C. Under this color assignment, the algorithms for sub-pixel rendering discussed below would work similarly.

Not only may the green or the red sub-pixels occupy the majority colored sub-pixels in octal grouping 120; but the blue sub-pixels may also occupy the majority sub-pixels. Thus, all three colors - red, green, and blue - may occupy the majority sub-pixel position in this grouping. Additionally, while the colors - red, green and blue - have been used for the purposes of illustrating the present embodiments, it should be appreciated that another suitable choice of three colors - representing a suitable color gamut for a display - may also suffice for the purposes of the present invention.

As shown in Figures 1A, 1B and 1C, the subpixels appear to have a substantially rectangular appearance. It should be appreciated that other shapes to the subpixels are also possible and are contemplated within the scope of the present invention. For example, a multitude of other regular or irregular shapes for the subpixels are possible and are desirable if manufacturable. It suffices only that there is an octal grouping of colored subpixels in the fashion herein described that may be addressable for the purposes of subpixel rendering (SPR).

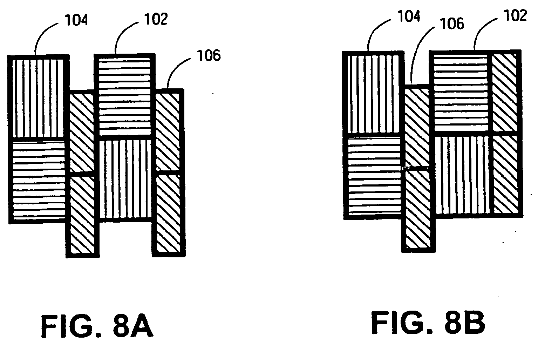

As subpixel shapes may vary under the scope of the present invention, so too may the exact positions of the subpixels be varied under the scope of the present invention. For example, Figures 8A and 8B depict a similar octal subpixel grouping wherein one or both of the majority stripes 106 are offset (relatively or otherwise) from the other subpixels 102 and 104. Other vertical offsets are also possible.

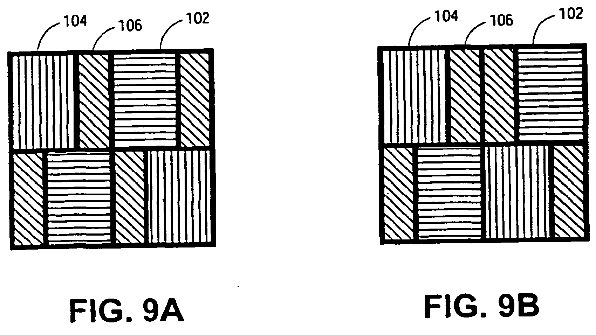

Other embodiments of octal groupings not falling within the scope of the claims are also possible. Figures 9A and 9B depict octal groupings wherein the majority subpixels 106 are interspersed within the checkerboard of subpixels 102 and 104. Other arrangements of majority subpixel placement within such a checkerboard are also possible.

Figures 9A and 9B may have column electrodes that zig-zag across the display. Column driver savings should be one third when compared to the RGB stripe system with the same resolution and the number of subpixels are about two thirds of the number of subpixels when compared to the RGB stripe system.

Yet other embodiments of the present invention are possible. For example, the entire octal subpixel groupings maybe rotated 90 degrees to reverse the roles of row and column driver connections to the grouping. Such a horizontal arrangement for subpixels is further disclosed in the co-pending application entitled "COLOR DISPLAY HAVING HORIZONTAL SUB-PIXEL ARRANGEMENTS AND LAYOUTS" (US 2003/0090581).

The alternating "checkerboard" of emitters is similar to the red and green "checkerboard" that was disclosed in co-pending and commonly assigned U.S. Patent Application No. 09/916,232 ("the '232 application") (US 2002/0015110), entitled "ARRANGEMENT OF COLOR PIXELS FOR FULL COLOR IMAGING DEVICES WITH SIMPLIFIED ADDRESSING," filed on July 25, 2001, using sob-pixel rendering such as that described in cop-ending U.S. Patent Application No. 10/150,355 ("the '355 application") (US 2003/0103058), entitled "METHODS AND SYSTEMS FOR SUB-PIXEL RENDERING WITH GAMMA ADJUSTMENT," filed on May 17, 2002. The methods described in the above co-pending applications maybe modified for the embodiments disclosed herein.

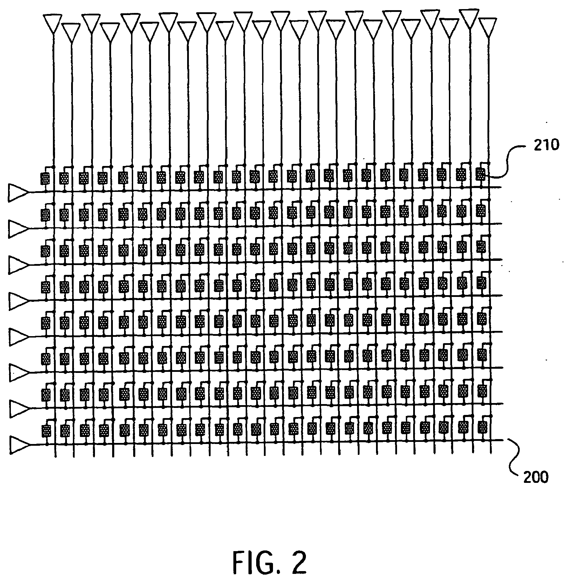

Figure 2 illustrates a schematic for a driver arrangement 200 for the arrangement of color emitter sub-pixels in Figures 1A, 1B, and 1C. For convenience, the example given has the same number of sub-pixels illustrated as Figure 1C. This drive arrangement may be used for a number of display technologies, as the blocks 210 may represent one or several electrical components, which are not shown so as not to obscure the embodiments. In particular, they may represent the capacitive display cell element for passively addressed Liquid Crystal Display (LCD), or ElectroLuminescent (EL) Display. They may represent the gaseous discharge element in a Plasma Display Panel (PDP). They may represent the semiconductor diode element of a passively addressed Inorganic Light Emitting Diode or an Organic Light Emitting Diode Display. They may also represent the transistor, storage capacitor, and capacitive cell element of an Active Matrix Liquid Crystal Display (AMLCD). They may further represent the multi-transistor, storage capacitor, and light emitting element of an Active Matrix Organic Light Emitting Diode Display (AMOLED). The may also represent, in general, the color sub-pixel and its associated electronic elements found in other known or yet to be developed display technologies.

The drive timing and method may be any of those known in the art for N X M drive matrices as those shown. However, there may be modifications needed due to the specific color assignments, particularly any checkerboard across the panel or color alternations within a single column. For example, the technique known in the art as "Multi-Row Addressing" or "Multi-Line Addressing" for passive LCD may be modified such that groupings of rows are restricted to odd and even row combinations. This will reduce potential color crosstalk since, within a column with two alternating color sub-pixels, only one color will be addressed at a time.

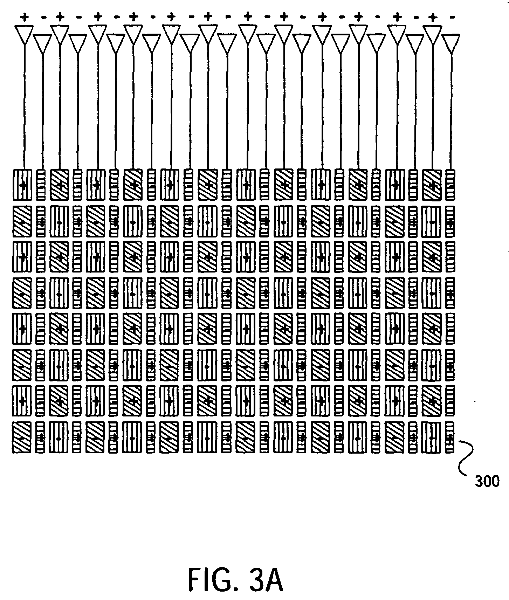

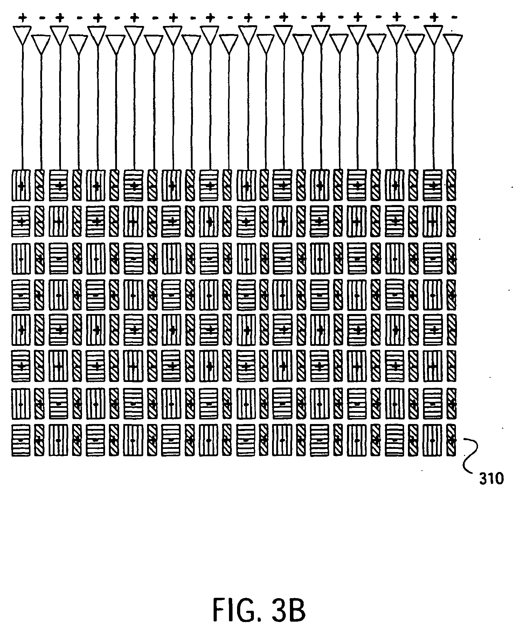

Inversion schemes, switching the electrical field polarity across the display cell to provide a time averaged zero net field and ion current across the cell, can be applied to the embodiments disclosed herein. Figures 3A and 3B show two "dot inversion" schemes 300 and 310, referred to as "1x1" and "2x1", respectively, on Active Matrix Liquid Crystal Displays, both of which will perform satisfactorily. The scheme shown on Figure 3B may perform better when slight imbalances of light transmission occur between positive and negative polarities, especially when the eye is tracking the motion of displayed images moving across the screen. Each of the Figures shows the polarities during half of the display addressing fields. The polarities are reversed for the other half, alternating every field, resulting in a net zero current (zero DC bias), as is well known in the art.

### Data Format Conversion

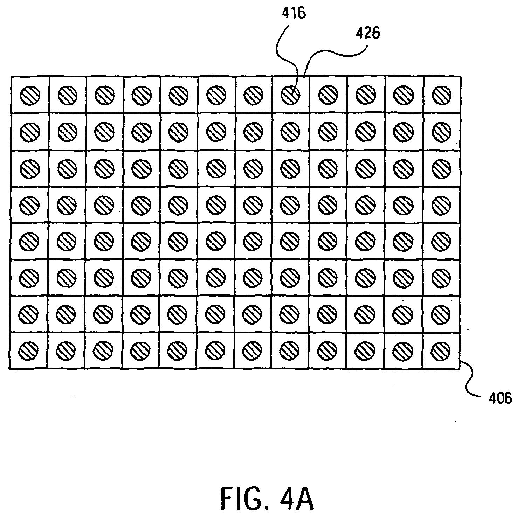

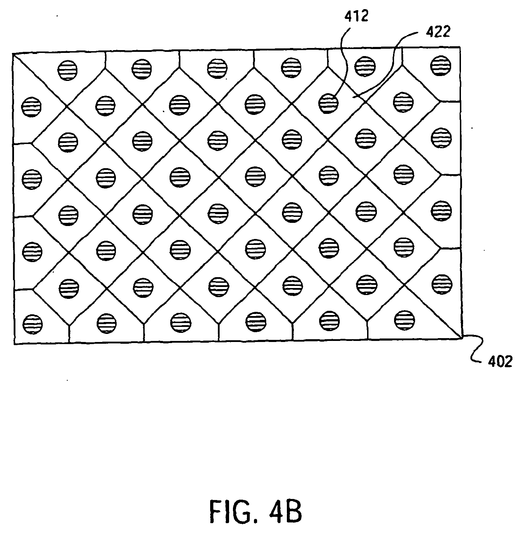

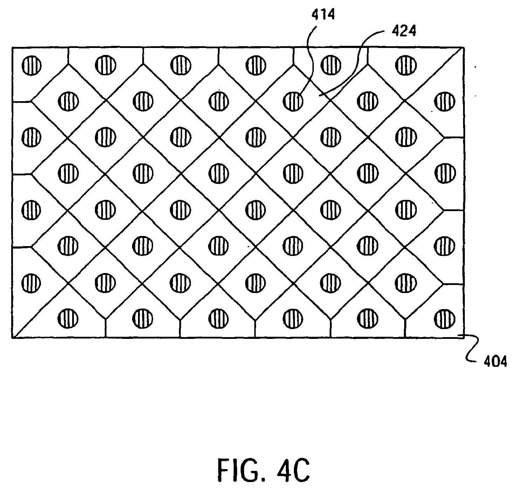

For one embodiment of data format conversion using area resampling techniques, Figures 4A, 4B, and 4C illustrate green 406, blue 402, and red 404 resample area arrays for the green, blue, and red color planes, respectively. Note that each color resample area array 406, 402, and 404 consists of resample areas 426, 422, and 424 and that each resample area has an associated resample point 416, 412, and 414, respectively, associated with it. The resample points 416, 412, and 414 match the relative positions of the green 106, blue 102, and red 104 sub-pixel locations respectively, within each color plane; but not necessarily their exact inter-color-plane-phase relationships. It should be appreciated that any number of phase relationships are also possible.

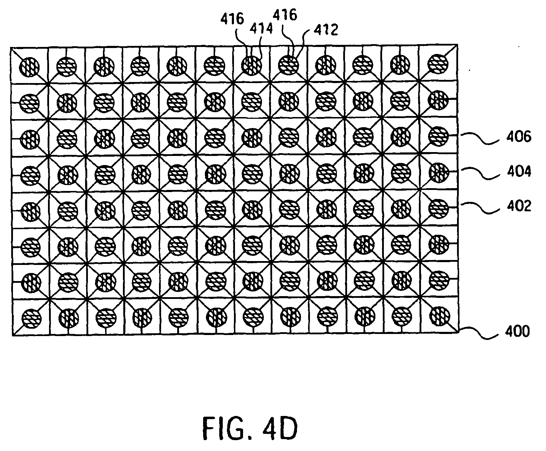

Figure 4D illustrates one particular inter-color-plane-phase relationship 400. This relationship might be employed to convert the conventional fully converged square grid RGB format which is to be displayed "one-to-one" with the square green 106 sub-pixel grid of Figure 1C. In this inter-color-plane-phase relationship 400, the green 406, blue 402, and red 404 resample area arrays are substantially positioned such that the red 414 and blue 412 resample points overlap the green 416 sample points. This treats the green sub-pixels 106 as though they lay on top of, or intimately associated with, the red 104 and blue 102 sub-pixel checkerboard.

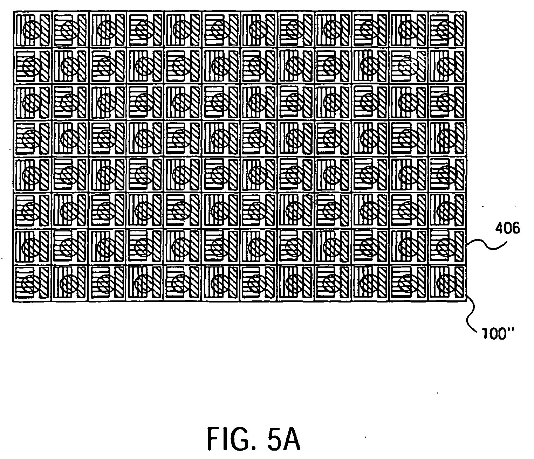

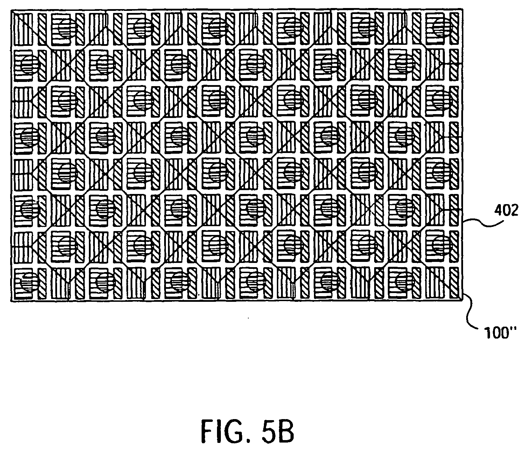

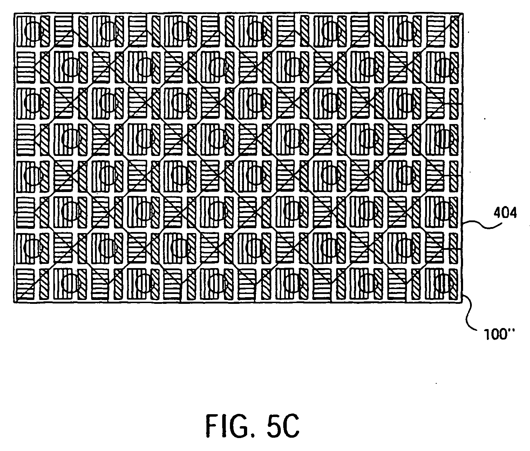

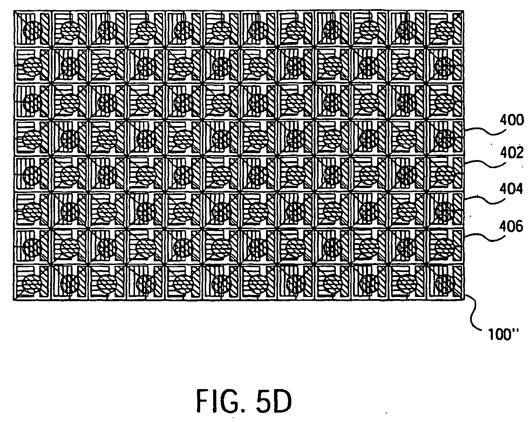

Figures 5A, 5B, and 5C illustrate the green 406, blue 402, and red 404 resample area arrays of Figures 4A, 4B, and 4C overlaid on the sub-pixel arrangement 100 of Figure 1C, respectively, with the inter-color-plane-phase relationship 400 of Figure 4D. Figure 5D illustrates the inter-color-plane-phase relationship 400 of Figure 4D overlaid on the sub-pixel arrangement 100 of Figure 1C. These Figures are merely illustrative and only serve to provide an understanding of the relationship between the resample points, reconstruction points, resample areas, and sub-pixel locations for this embodiment.

The above referenced '355 patent application describes the method used to convert the incoming data format to that suitable for the display. In such a case, the method proceeds as follows: (1) determining implied sample areas for each data point of incoming three-color pixel data; (2) determining the resample area for each color sub-pixel in the display; (3) forming a set of coefficients for each the resample area, said coefficients comprising fractions whose denominators are a function of the resample area and the numerators are a function of an area of each the implied sample areas that may partially overlap said resample areas; (4) multiplying the incoming pixel data for each implied sample area by the coefficient resulting in a product; (5) adding each the product to obtain luminance values for each resample area.

Examining a "one-to-one" format conversion case for the resample operation illustrated in Figure 4D and 5D, the green plane conversion is a unity filter. The red and blue color planes use a 3 X 3 filter coefficient matrix, derived as explained in detail in the '355 application:

| | | |
|---|---|---|
| 0 | 0.125 | 0 |
| 0.125 | 0.5 | 0.125 |
| 0 | 0.125 | 0 |

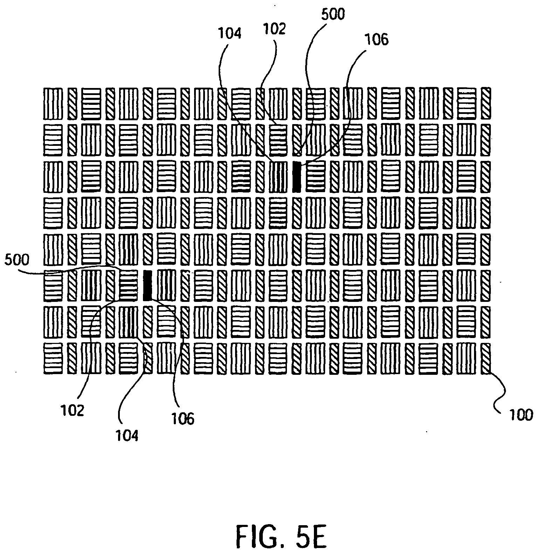

Figure 5E illustrates the results of turning on two full color incoming data pixels. The two pixels are converted to two clusters of sub-pixels, called "logical pixels" 500, turned on at varying amplitudes. One of the logical pixels is centered on or near a red sub-pixel 104. The green sub-pixel 106 is set at 100% illumination. The red sub-pixel 104 is set to 50% illumination, while the four surrounding blue sub-pixels 102 are set to 12.5% each. The result is a white dot visible to the human eye, centered between the red 104 and the green 106 sub-pixels. The other logical pixel 500 similarly has the green sub-pixel 106 set to 100% and the near by blue sub-pixel 102 set to 50% with the four surrounding red sub-pixels 104 set at 12.5% each.

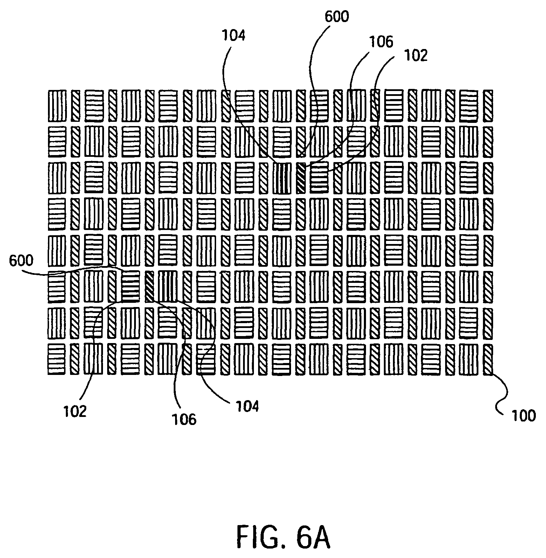

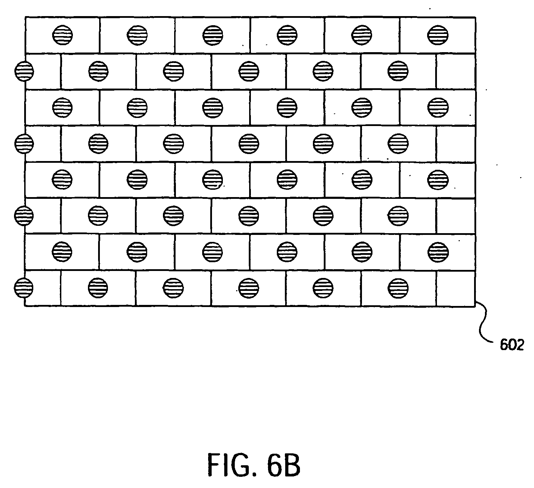

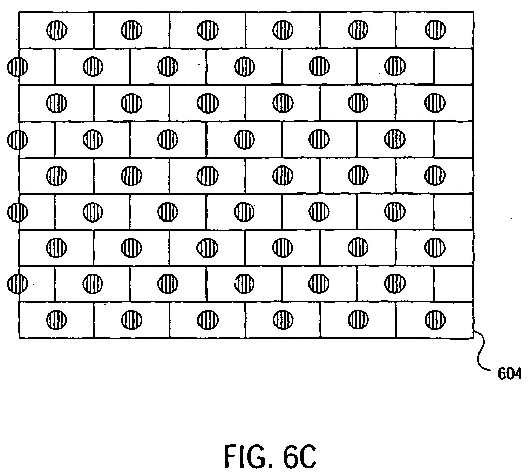

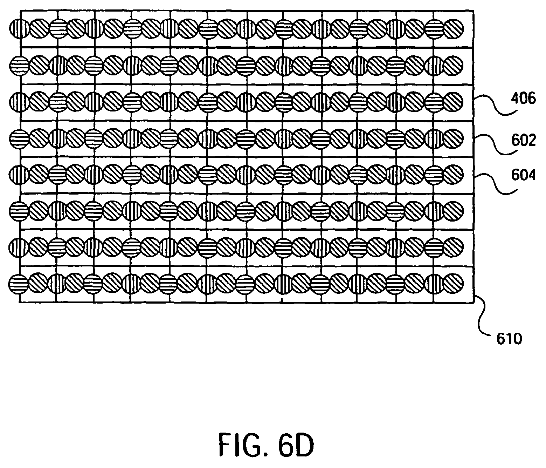

Figures 6B and 6C show an alternative blue 602 and red 604 color plane resample area arrays - shown herein as box filters ([0.5 0.5]) -- to replace the blue 402 and red 404 resample area arrays of Figures 4B and 4C, respectively. Figure 6D illustrates an inter-color-plane-phase relationship 610 using the green 406, blue 602, and red 604 resample area arrays. Figure 6A shows the resulting logical pixels 600 from turning on two input data format pixels using resample operation of the inter-color-plane-phase relationship 610 from input data with a "one-to-one" pixel to green sub-pixel 106 mapping. These logical pixels 600 maybe in the same relative positions as the two logical pixels 500 in Figure 5E. Also, it may be possible to center the green box filter to match substantially an input pixel by adjusting the grid slightly.

Adaptive filtering techniques can also be implemented with the pixel arrangements disclosed herein, as further described below.

Again, the green resample uses a unitary filter. The red and blue color planes use a very simple 1 X 2 coefficient filter. [0.5 0.5]

An adaptive filter, similar to that disclosed in the co-pending and commonly assigned U.S. Patent Application No. 10/215,843 ("the '843 application") (US 2003/0085906), entitled "METHODS AND SYSTEMS FOR SUB-PIXEL RENDERING WITH ADAPTIVE FILTERING," filed on August 8, 2002, can be adopted so as not to require a 3x3 sample of input data, which uses a minimum of two lines of memory. The test may be based on a smaller sample of input data, for example 1x3 or 1x2 matrices. The green data is sampled to test for vertical or diagonal lines and then the red and blue data adjacent to the green test point may be changed.

So, an adaptive filter test could be implemented as follows to test to see if a high contrast edge is detected: compare the green data (G) to a min value and a max value - if G < min or G > max, then a register value is set to 1, otherwise the register value is set to 0; compare the register values for three successive green data points to test masks to see if an edge is detected; if detected then take an appropriate action to the red and/or blue data - e.g. apply gamma or apply a new value or different filter coefficient.

The following table is illustrative of this embodiment:

| | | | |
|---|---|---|---|
| Data (for 3 successive points | 0.98 | 0.05 | 0.0 |
| Low Test (G < 0.1) | 0 | 1 | 1 |
| High Test (G > 0.9) | 1 | 0 | 0 |
| Compare low and NOT high | True | True | True |

For the example above, an edge has been detected and there is an array of options and/or actions to take at this point. For example, the gamma correction could be applied to the output of the box filter for red and/or blue; or a new fixed value representing the output required to balance color could be used; or use a new SPR filter.

The test for black lines, dots, edges and diagonal lines are similar in this case, since only three values are examined:

| | Register Value | | Binary no. | |
|---|---|---|---|---|
| 1. | 1 | 0 | 1 | 5 |
| 2. | 1 | 1 | 0 | 6 |
| 3. | 0 | 1 | 1 | 3 |

In the above table, the first row could represent a black pixel with white pixels on either side. The second row could represent an edge of a black line or dot. The third row could represent an edge of a black line in a different location. The binary numbers are used as an encoding for the test.

The test for white lines, dots, edges, and diagonal lines might be as follows:

| | Register value | | | Binary no. |
|---|---|---|---|---|
| 4. | 0 | 1 | 0 | 2 |
| 5. | 0 | 0 | 1 | 1 |
| 6. | 1 | 0 | 0 | 4 |

If the tests are true and the high and low tests are, for example, 240 and 16 (out of 255) respectively, then the output value for these edges using the box filter might be 128 +/- 4 - or some other suitable value. The pattern matching is to the binary numbers shown adjacent to the register values. A simple replacement of 128 raised to an appropriate gamma power could be output to the display. For example, for gamma = 2.2, the output value is approximately 186. Even though the input may vary, this is just an edge correction term so a fixed value can be used without noticeable error. Of course, for more precision, a gamma lookup table could likewise be used. It should be appreciated that a different value, but possibly similar, of correction could be used for white and black edges. It should likewise be appreciated that as a result of detecting an edge, the red and/or blue data could be acted on by a different set of filter coefficients - e.g. apply a [1 0] filter (i.e. unity filter) which would effectively turn off sub pixel rendering for that pixel value.

The above tests were primarily for a green test, followed by action on red and blue. Alternatively, the red and blue can be tested separately and actions taken as needed. If one desired to only apply the correction for black and white edges, than all three color data sets can be tested and the result ANDed together.

A further simplification could be made as follows. If only two pixels in a row are tested for edges, then the test above is further simplified. High and low thresholding may still be accomplished. If [0 1] or [1 0] is detected, then a new value could be applied - otherwise the original value could be used.

Yet another simplification could be accomplished as follows (illustrated for the red): subtract the red data value, Rₙ. from the red value immediately to the left, R_{n-1,} ; if the delta is greater than a predetermined number - say for example 240 - then an edge is detected. If an edge is detected, one could substitute a new value, or apply gamma, output the value Rₙ to the display, or apply new SPR filter coefficients; otherwise, if no edge is detected, output the results of the box filter to the display. As either Rₙ or Rₙ₋₁ may be larger, the absolute value of the delta could be tested. The same simplification could occur for the blue; but the green does not need to be tested or adjusted, if green is the split pixel in the grouping. Alternatively, a different action could be taken for falling edges (i.e. Rₙ - Rₙ₋₁ < 0) and rising edges (i.e. Rₙ - Rₙ₋₁ > 0 ).

The results are logical pixels 600 that have only three sub-pixels each. For a white dot and using a box filter for red and blue data, the green sub-pixels 106 are set to 100% as before. The nearby red 104, as well as the nearby blue 102, could be all set to 50%. The resample operation of inter-color-plane-phase relationship 610 of Figure 6D is very simple and inexpensive to implement, while still providing good image quality.

Both of the above data format conversion methods match the human eye by placing the center of logical pixels at the numerically superior green sub-pixels. The green sub-pixels are each seen as the same brightness as the red sub-pixel, even though half as wide. Each green sub-pixel 106 acts as though it were half the brightness of the associated logical pixel at every location, while the rest of the brightness is associated with the nearby red sub-pixel illuminated. Thus, the green serves to provide the bulk of the high resolution luminance modulation, while the red and blue provide lower resolution color modulation, matching the human eye.

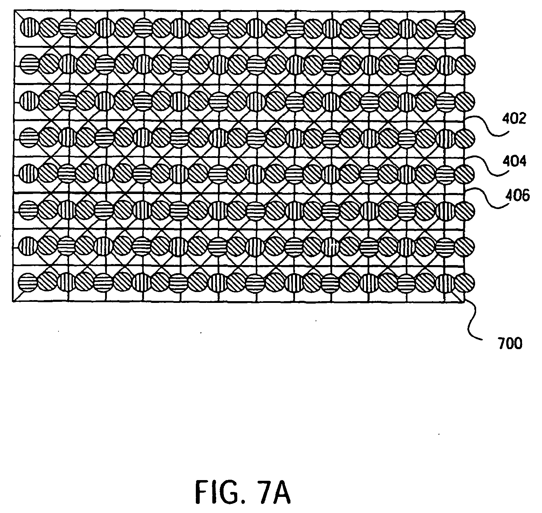

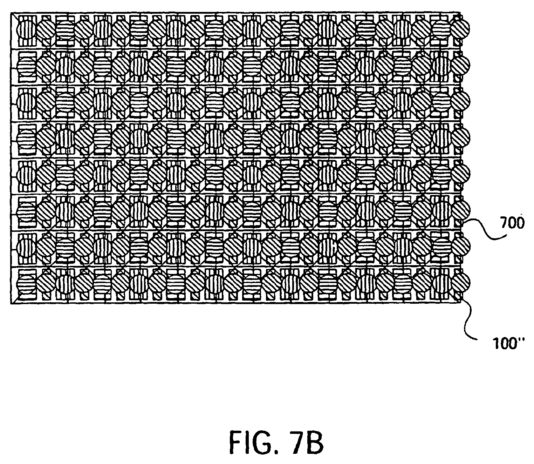

Figure 7A illustrates an alternative inter-color-plane-phase relationship 700 using the green 406, blue 402, and red 404 resample area arrays of Figures 4A, 4B, and 4C. Note that in this inter-color-plane-phase relationship 700 has the same relative phase as the color sub-pixel arrangement 100 as illustrated in Figure 7B. Note that the relative phases of the resample points of this inter-color-plane-phase relationship 700 is the same as that for the inter-color-plane-phase relationship 610. If this inter-color-plane-phase relationship 700 were used for the "one-to-one" data format conversion, the green would again be a unitary filter, while the red and blue would use 3 X 2 coefficient filter kernel:

| | |
|---|---|
| 0.0625 | 0.0625 |
| 0.375 | 0.375 |
| 0.0625 | 0.0625 |

Note that the two columns add up to 0.5 each, similar to the coefficients for the red and blue resample filter operation for the inter-color-plane-phase relationship 610.

This inter-color-plane-phase relationship 700 shown in Figure 7A is useful for scaling, both up and down, of conventional format data sets. The area resample method of calculation of the filter coefficients and keeping track of the input and output data buffers was described in the referenced '355 application. However, according to another embodiment, while the red and blue color planes may be area resampled, it may be advantageous to calculate the filter coefficients for the square grid of green sub-pixels 106 using a novel implementation of a bi-cubic interpolation algorithm for scaling up data sets while converting them to be displayed on the arrangement of color sub-pixels 100 of Figure 1C.

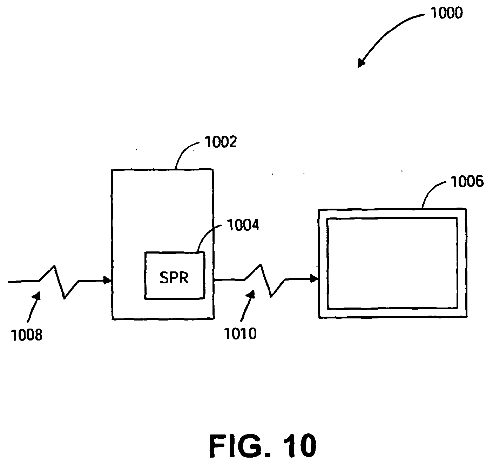

Figure 10 depicts a system 1000 in which a display as constructed in accordance with the various embodiments disclosed herein is driven by a sub-pixel rendering technique 1004 which may be resident on a physical device 1002. An input image data stream 1008 may be input into the sub-pixel rendering technique 1004 and converted in the manner herein disclosed. An output image data stream 1010 is sent to the display device 1006 in order to drive the various sub-pixels to form an image thereupon. As discussed in several references cited herein, the sub-pixel rendering (SPR) technique 1004 may be implemented in either hardware and/or software or a combination thereof. For example, SPR techniques 1004 could be resident as logic (either hardware or software) on the display itself or it could reside on a graphics controller chip or board.

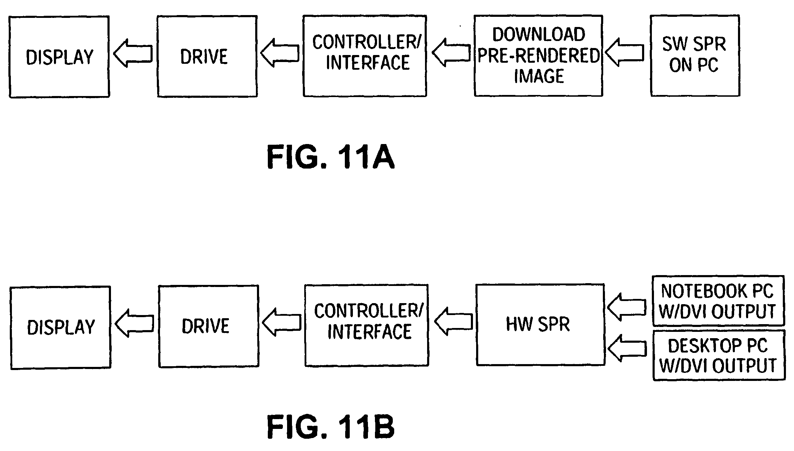

Figures 11A and 11B depict two particular flowchart embodiments disclosing sub-pixel rendering in software and hardware respectively. In Figure 11A, SPR may be accomplished in advance on a PC or other processing system and/or means. From there, the pre-rendered images could be downloaded to a controller/interface and sent along to a drive running the display. In Figure 11B, image data may be input from many different sources - for example, a notebook PC with DVI output or a desktop with DVI output - to a hardware module doing SPR. From there, the sub-pixel rendered data could be sent ultimately to the display via a controller/interface and a drive. Of course, other hardware and software implementations are possible and that Figures 11A and 11B merely describe two possible such implementations.

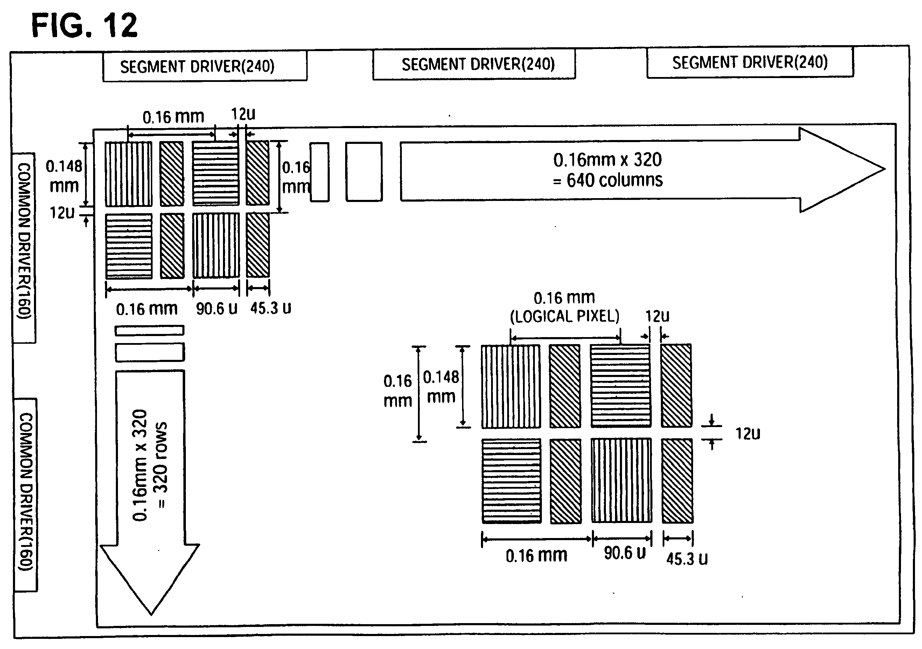

Figure 12 shows one particular display embodiment for a 320x320 STN display using the sub-pixel repeat cell as disclosed herein. Although various sub-pixel dimensions are also disclosed in Figure 12, it should be appreciated that other dimensions would also suffice and that Figure 12 is merely offered for illustrative purposes for a single embodiment

While the invention has been described with reference to exemplary embodiments, it will be understood that various changes may be made and equivalents may be substituted for elements thereof without departing from the scope of the invention. In addition, many modifications may be made to adapt a particular situation or material to the teachings without departing from the essential scope thereof. For example, some of the embodiments above may be implemented in other display technologies such as Organic Light Emitting Diode (OLED), ElectroLumenscent (EL), Electrophoretic, Active Matrix Liquid Crystal Display (AMLCD), Passive Matrix Liquid Crystal display (AMLCD), Incandescent, solid state Light Emitting Diode (LED), Plasma Display Panel (PDP), and Iridescent. Therefore, it is intended that the invention not be limited to the particular embodiment disclosed as the best mode contemplated for carrying out this invention, but that the invention will include all embodiments falling within the scope of the appended claims.

## Claims

1. A display comprising a plurality of a sub-pixel group; said sub-pixel group further comprising eight sub-pixels arranged in a matrix of rows and columns;
wherein each said sub-pixel is one of a first color sub-pixel (106), a second color sub-pixel (104) and a third color sub-pixel (102);
wherein said sub-pixel group further comprises four sub-pixels of said first color (106), two sub-pixels of said second color (104) and two sub-pixels of said third color (102);
wherein further said sub-pixels of said second color (104) and said sub-pixels of said third color (102) form a checkerboard pattern such that the two sub pixels (104) of said second color are disposed in different rows and in different columns of the sub-pixel repeating group and such that the two sub pixels (106) of said third color are disposed in different rows and in different columns of the sub-pixel repeating group,
**characterised in that** each of said sub-pixels of said first color (106) comprises a smaller area than each of said sub-pixels of said second color (104) and each of said sub-pixels of said third color (102).

2. The display as recited in Claim 1 wherein said first color (106) comprises a green color and each said second color (104) and said third color (102) comprises one of a red color and a blue color, respectively.

3. The display as recited in Claim 1 wherein said first color (106) comprises a red color and each said second color (104) and said third color (102) is one of a green color and a blue color, respectively.

4. The display as recited in Claim 1 where said sub-pixel group further comprises substantially two rows and four columns of sub-pixels; and
wherein further a first set of two non-adjacent columns comprises four sub-pixels of said first color (106) and a second set of two non-adjacent columns comprises two sub-pixels of said second color (104) and two sub-pixels of said third color (102).

5. The display as recited in Claim 4 wherein said two non-adjacent columns comprising four sub-pixels of said first color (106) are offset vertically from said two non-adjacent columns comprising two sub-pixels of said second color (104) and two sub-pixels of said third color (102).

6. The display as recited in Claim 1 wherein said sub-pixels of said first color (106) are interspersed said substantially formed checkerboard pattern of sub-pixels of said second color (104) and said third color (102).

7. The display as recited in Claim 1 wherein said display is an active matrix liquid crystal display.

## Patentansprüche

1. Anzeige, umfassend eine Mehrzahl von einer Unterpixelgruppe; wobei die Unterpixelgruppe ferner acht Unterpixel umfasst, welche in einer Matrix von Reihen und Spalten arrangiert sind;
wobei jedes der Unterpixel eines ist aus einem erste-Farbe-Unterpixel (106), einem zweite-Farbe-Unterpixel (104) und einem dritte-Farbe-Unterpixel (102);
wobei die Unterpixelgruppe ferner umfasst: vier Unterpixel der ersten Farbe (106), zwei Unterpixel der zweiten Farbe (104) und zwei Unterpixel der dritten Farbe (102);
wobei ferner die Unterpixel der zweiten Farbe (104) und die Unterpixel der dritten Farbe (102) ein Schachbrettmuster ausbilden, sodass die zwei Unterpixel (104) der zweiten Farbe in unterschiedlichen Reihen und in unterschiedlichen Spalten von der Unterpixelwiderholungsgruppe angeordnet sind und sodass die zwei Unterpixel (106) der dritten Farbe in unterschiedlichen Reihen und in unterschiedlichen Spalten von der Unterpixelwiderholungsgruppe angeordnet sind,
**dadurch gekennzeichnet, dass** jedes der Unterpixel der ersten Farbe (106) eine Fläche umfasst, welche kleiner ist als jedes der Unterpixel der zweiten Farbe (104) und jedes der Unterpixel der dritten Farbe (102).

2. Anzeige nach Anspruch 1, wobei die erste Farbe (106) eine grüne Farbe umfasst und jeweils jedes aus der zweiten Farbe (104) und der dritten Farbe (102) eines aus einer roten Farbe und einer blauen Farbe umfasst.

3. Anzeige nach Anspruch 1, wobei die erste Farbe (106) eine roten Farbe umfasst und jeweils jedes aus der zweiten Farbe (104) und der dritten Farbe (102) eines aus einer grüne Farbe und einer blauen Farbe ist.

4. Anzeige nach Anspruch 1, wobei die Unterpixelgruppe ferner im Wesentlichen zwei Zeilen und vier Spalten von Unterpixeln umfasst; und
wobei ferner ein erster Satz aus zwei nicht-benachbarten Spalten vier Unterpixel der ersten Farbe (106) umfasst und ein zweiter Satz aus zwei nicht-benachbarten Spalten zwei Unterpixel der zweiten Farbe (104) und zwei Unterpixel der dritten Farbe (102) umfasst.

5. Anzeige nach Anspruch 4, wobei die zwei nicht-benachbarten Spalten, welche vier Unterpixel der ersten Farbe (106) umfassen, vertikal versetzt sind bezüglich den zwei nicht-benachbarten Spalten, welche zwei Unterpixel der zweiten Farbe (104) und zwei Unterpixel der dritten Farbe (102) umfassen.

6. Anzeige nach Anspruch 1, wobei die Unterpixel der ersten Farbe (106) eingestreut sind das im Wesentlichen ausgebildete Schachbrettmuster von Unterpixeln der zweiten Farbe (104) und der dritten Farbe (102).

7. Anzeige nach Anspruch 1, wobei die Anzeige eine Aktiv-Matrix-Flüssigkristall-Anzeige ist.

## Revendications

1. Dispositif d'affichage comprenant une pluralité d'un groupe de sous-pixels ; ledit groupe de sous-pixels comprenant en outre huit sous-pixels agencés en une matrice de rangées et de colonnes ;
dans lequel chacun desdits sous-pixels est l'un parmi un sous-pixel de première couleur (106), un sous-pixel de deuxième de couleur (104) et un sous-pixel de troisième couleur (102) ;
dans lequel ledit groupe de sous-pixels comprend en outre quatre sous-pixels de ladite première couleur (106), deux sous-pixels de ladite deuxième couleur (104) et deux sous-pixels de ladite troisième couleur (102) ;
dans lequel en outre lesdits sous-pixels de ladite deuxième couleur (104) et lesdits sous-pixels de ladite troisième couleur (102) forment un motif en damier de sorte que les deux sous-pixels (104) de ladite deuxième couleur soient disposés dans des rangées différentes et dans des colonnes différentes du groupe de répétition de sous-pixels et de sorte que les deux sous-pixels (106) de ladite troisième couleur soient disposés dans des rangées différentes et dans colonnes différentes du groupe de répétition de sous-pixels ,
**caractérisé en ce que** chacun desdits sous-pixels de ladite première couleur (106) comprend une zone plus petite que celle de chacun desdits sous-pixels de ladite deuxième couleur (104) et de chacun desdits sous-pixels de ladite troisième couleur (102).

2. Dispositif d'affichage selon la revendication 1, dans lequel ladite première couleur (106) comprend une couleur verte et chacune de ladite deuxième couleur (104) et de ladite troisième couleur (102) comprend l'une parmi une couleur rouge et une couleur bleue, respectivement.

3. Dispositif d'affichage selon la revendication 1, dans lequel ladite première couleur (106) comprend une couleur rouge et chacune de ladite deuxième couleur (104) et de ladite troisième couleur (102) est l'une parmi une couleur verte et une couleur bleue, respectivement.

4. Dispositif d'affichage selon la revendication 1, où ledit groupe de sous-pixels comprend en outre essentiellement deux rangées et quatre colonnes de sous-pixels ; et
dans lequel en outre un premier ensemble de deux colonnes non adjacentes comprend quatre sous-pixels de ladite première couleur (106) et un deuxième ensemble de deux colonnes non adjacentes comprend deux sous-pixels de ladite deuxième couleur (104) et deux sous-pixels de ladite troisième couleur (102).

5. Dispositif d'affichage selon la revendication 4, dans lequel lesdites deux colonnes non adjacentes comprenant quatre sous-pixels de ladite première couleur (106) sont décalées verticalement par rapport auxdites deux colonnes non adjacentes comprenant deux sous-pixels de ladite deuxième couleur (104) et deux sous-pixels de ladite troisième couleur (102).

6. Dispositif d'affichage selon la revendication 1, dans lequel lesdits sous-pixels de ladite première couleur (106) sont intercalés à l'intérieur dudit motif en damier formé essentiellement de sous-pixels de ladite deuxième couleur (104) et de ladite troisième couleur (102).

7. Dispositif d'affichage selon la revendication 1, dans lequel ledit dispositif d'affichage est un dispositif d'affichage à cristaux liquides à matrice active.
